# EUROPEAN PATENT APPLICATION

(11) **EP 3 961 091 A1**
(43) Date of publication of application: **02.03.2022**
(21) Application number: 20193712.5
(22) Date of filing: 31.08.2020
(51) Int. Cl.: F21V 9/40, F21V 14/00, H05B 45/327, F21V 23/04, F21V 1/10, H01H 36/00

(54) **A LIGHT FIXTURE HAVING LIGHT DIMMING MAGNETIC MEANS**

(71) Applicant: Astep ApS, 2100 Copenhagen Ø (DK)
(72) Inventor: Zambetti, Nicholas, 2100 Copenhagen Ø (DK); Faccin, Francesco, 2100 Copenhagen Ø (DK); Longhin, Silvio, 2100 Copenhagen Ø (DK); Sarfatti, Alessandro, 2100 Copenhagen Ø (DK)
(74) Representative: Plougmann Vingtoft a/s

(57) **Abstract**

The present invention relates to a light fixture having magnetic light dimming means.

## Description

### FIELD OF THE INVENTION

The present invention relates to a light fixture having a light dimming magnetic means.

### BACKGROUND OF THE INVENTION

Dimming systems for light fixture are energy saving and environmental friendly systems allowing for reducing light brightness in luminaries.

The reduction of the brightness in light fixtures, achieved through the use of light dimming system, limits the consumption of energy and increases the lifetime of light sources.

However, currently light dimming solutions may be unreliable, difficult to use and generally produce segmented dimming through two or more dimming steps.

Hence, there is the need for a reliable, simple to use, stepless dimming system that allows for easy control of continuous light dimming.

An improved light fixture comprising a dimming system that provides a reliable, easy to use, continuous light dimming would thus be advantageous, and in particular, a more efficient light fixture comprising a dimming system allowing for dimming function to be easily performed, would be advantageous.

### OBJECT OF THE INVENTION

An object of the present invention is to provide a light fixture having an easy to use, simple to assemble, reliable and continuous light dimming.

An object of the present invention may also be seen as to provide an alternative to the prior art.

In particular, it may be seen as an object of the present invention to provide a a light fixture containing a reliable, easy to use, continuous light dimming device that solves the above-mentioned problems of the prior art by employing light dimming magnetic means.

### SUMMARY OF THE INVENTION

Thus, the above-described object and several other objects are intended to be obtained in a first aspect of the invention by providing a light fixture comprising: one or more sources of light; a magnetic rotary dimming system comprising: a movable plate rotatable around or about an axis of the movable plate; a permanent magnet; a magnetic sensor device located onto the movable plate mounted at a distance from the permanent magnet; wherein the magnetic sensor device comprises at least one magnetic sensor for measuring at least one magnetic field component and the magnetic sensor is configured for determining an angular position of the permanent magnet; electronics connecting the one or more sources of light and the magnetic sensor device, the electronics configured to dim the one or more sources of light based on the detection of the angular position of the permanent magnet.

A light fixture or light fitting or luminaire is defined as an electrical device that contains at least one electric light source, such as a lamp, providing illumination.

The movable plate may rotate around a rotation axis perpendicular or substantially perpendicular to the movable plate. Thus, the axis referred to in the first aspect of the invention may be the rotation axis perpendicular or substantially perpendicular to the moveable plate.
The movable plate may have any polygonal shape, such as square or triangular, or any other shape, such as circular or semi-circular.

The permanent magnets may be magnetised in a direction perpendicular or substantially perpendicular to the rotation axis.

The magnetic sensor device may be configured for determining at least one magnetic field gradient, and thus, in turn configured for determining an angular position of the permanent magnet based on the at least one magnetic field gradient. As a function of the detection of the position of the magnet, the brightness of the one or more sources of light is varied.

The electronics are functionally connected, directly or indirectly, to the one or more sources of light, so that upon rotation or following a predetermined motion sequence and upon detection of the position of the magnet, the electric current feeding the one or more sources of light is adjusted, such as linearly adjusted, producing variation of the brightness of the light.

The combination of the movable plate, magnetic sensor device, permanent magnet and electronics of the invention provides variation of the brightness of the one or more sources of lights through continuous rotation in either clockwise or counter clockwise directions of the movable plate.

The unique combination of these elements also provides for a continuos dimming, i.e. limitless rotation either clockwise or conterclockwise exceeding 360° degrees. A user may thus endlessly rotate the dimming device as no intanglement of wires may occur since the dimming device is wireless, i.e. no electro-mechanical connection is present between the moveable plate and the lower part of the light fixture.

In some embodiments, the light fixture comprises a light fixture body having an upper and a lower element configured to rotate in respect to each other around a central axis of the light fixture body.

The central axis may be the longitudinal axis of the light fixture body.

The lower element and upper element are two completely separated entities. Advantegeously, there is no electro-mechanical connection between the lower element and the upper element. This configuration allows for limitless rotation between the two elements. This configuration has also the advantage of allowing for production of water proof, separately sealed elements.

In some further embodiments, the lower element comprises the permanent magnet and the upper element comprises the movable plate.

In some other embodiments, the lower element comprises the movable plate and the upper element comprises the permanent magnet.

In some further embodiments, the electronics are located onto the movable plate.

In some other embodiments, the electronics are within the movable plate.

In some other embodiments, the electronics are or comprise a printed circuit board (PCB).
A PCB mechanically supports and electrically connects electrical or electronic components using conductive tracks, pads and other features etched from, for example, one or more sheet layers of copper laminated onto and/or between sheet layers of a non-conductive substrate.
Components and sources of lights are generally soldered onto the PCB to both electrically connect and mechanically fastened them to it.

In some embodiments, the one or more sources of light are located onto the movable plate.

In some embodiments, the movable plate may be a disc, such as a metal disc, with perforations allowing for transmittance of the light beam originated by the one or more sources of light.

In some other embodiments, the one or more sources of light are within the movable plate.

The advantage of using a movable plate that comprises the one or more sources of light is the reduction of the overall complexity of the light fixture and thus the reduction of costs and need for maintenance.

In some preferred embodiments, the one or more sources of light encircle, such as surround, the electronics.

The light fixture may further comprise optical means for enhancing light emission from the one or more sources of light.

The optical means may be located, such as mounted and fastened, onto the movable plate.

In some embodiments, the movable plate has a top and a bottom surface.

The optical means may be located on or may be within the top surface of the movable plate.

The optical means may be or comprise one or more light reflecting surfaces or reflectors for enhancing light emission. The light reflecting surface may be located within the upper element of the light fixture body. In some other embodiments, the light reflecting surface may be located within the lower element of the light fixture body.

In some embodiments, the optical means are or comprise one or more lenses located onto the movable plate.

In some other embodiments, the optical means are or comprise one or more lenses within the movable plate.

The one or more lenses may be plano convex lenses collimating the light beam originated by the one or more sources of light.

Other type of lenses may also be used, such as plano concave lenses, as optical means onto or within the movable plate.

The one or more sources of light may be any source of lights or bundle of lights, such as lamps bulb or halogen bulbs.

In a preferred embodiment, the one or more sources of light are Light Emitting Diodes (LEDs).

For example, the one or more sources of light may be the LEDs from a LED strip, such as LED tape or ribbon light.

Upper element and lower element may be separable elements, allowing for easy maintenance.

Lower element and upper element may be fastened by complementary parts located on opposite surfaces.

In some embodiments, the lower element and upper element may be fastened by complementary parts such as a screw and a recess.
The screw, located on the upper element, may have an external thread configured to engage with the internal thread of a recess located on the lower element. In some embodiments, the screw may be located on the lower element, while the recess may be located on the upper element.

In some other embodiments, the complementary parts may be one or more protrusions and complementary recesses configured for fasting the lower element and the upper element by press fit.

Lower element and upper element may thus be fastened by pushing, pulling, screwing or through the use of fastening tools.

In some embodiments, the movable plate is fastened to the lower element of the light fixture body by snap-lock means, which allows for rotation around a rotation axis, such as the rotation axis perpendicular to the movable plate.

In some embodiments, the lower element comprises at least one protrusion complementary to at least two recesses on the movable plate, thereby providing a visual, audible or tactile signal at a determined angle of rotation.

In some other embodiments, the at least one protrusion may be located on the movable plate while the at least two recesses may be located within the lower element.

The at least one protrusion and at least two recesses provide a detent arresting the rotation at a determined or desired angle of rotation.

When in operation, upon rotation, the at least one protrusion will snap into one of the at least two recesses providing a snap engagement producing a distinct audible sound and/or a tactile signal felt by a person holding the lamp fixture.

In some embodiments, the snap engagement may also be visible, thus the combination of the at least one protrusion and one of the at least two recesses may provide also a visual signal at a determined angle of rotation.

The at least one protrusion may be or may comprise a spring plunger, such as a ball plunger.

A spring plunger is defined as a device that encloses a spring in a threaded capsule and provides a means of applying accurate and repeatable spring end forces through a ball or rounded nose.

The spring plunger, according to some embodiments of the invention, is used for locking into position with the complementary recesses so as to provide a signal at a determined angle of rotation.
In some embodiments, the spring plunger is a ball plunger. Ball plungers comprises a ball instead of a nose. The ball has little depth, which allows for movement in and out of position.
As the contact force puts pressure on the ball of the ball plunger, it depresses in to the body forcing the internal spring to compress. When the ball meets the recess, compression is released and at least part of the ball is locked into position inside the recess.

The at least two recesses may be holes or grooves on the bottom surface of the movable plate.

The lamp fixture of the invention may be powered by batteries or may be powered by an external source of electricity, such as, may be connectable to the grid.

The first and other aspects and embodiments of the present invention may each be combined with any of the other aspects and embodiments. These and other aspects of the invention will be apparent from and elucidated with reference to the embodiments described hereinafter.

### BRIEF DESCRIPTION OF THE FIGURES

The light fixture according to the invention will now be described in more details with regard to the accompanying figures. The figures show one way of implementing the present invention and are not to be construed as being limiting to other possible embodiments falling within the scope of the attached claim set.
Figure 1A is a schematic illustration of the light fixture according to some embodiments of the invention.
Figure 1B and Figure 1C are graph of the light brightness as related to the rotation angle of the light fixture according to some different embodiments of the invention.
Figure 2 is an exploded view of a compact version of the light fixture according to some embodiments of the invention.
Figure 3 is an exploded view of the light fixture comprising a separate movable plate, according to some other embodiments of the invention.
Figure 4 is an exploded view of the light fixture comprising optical means according to some further embodiments of the invention.
Figure 5 is a schematic illustration of the essential features of the magnetic rotary dimming system according to some embodiments of the invention.
Figure 6 is a schematic illustration of the magnetic rotary dimming system comprising an audible or tactile signalling means, according to some other embodiments of the invention.

### DETAILED DESCRIPTION OF AN EMBODIMENT

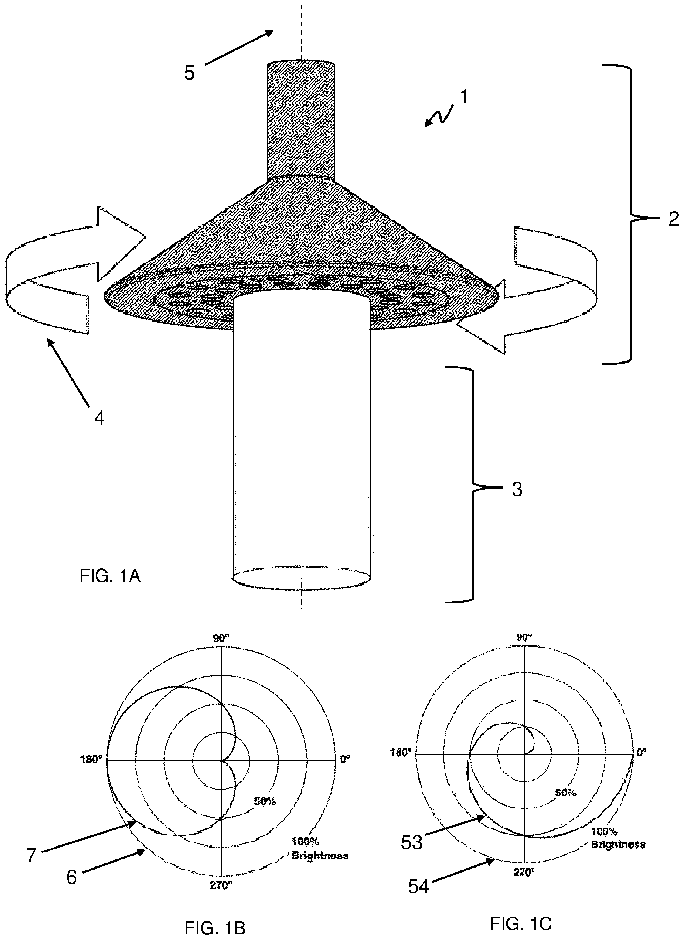

Figure 1A is a schematic illustration of the light fixture 1 having an upper part or element 2 and a lower part or element 3. The upper part can be rotated according to a clockwise direction 4 around the light fixture or lamp longitudinal axis 5 so as to dim the light intensity or brightness of the light fixture.

Figure 1B shows a graph in polar coordinates, having as dimensions the angle of rotation and distance between permanent magnet and sensing device. Figure 1B represents rotation and brightness of the light as a function of the rotation angle of the light fixture. The external circle is marked with degrees that correspond to the angles of rotation, i.e. 0°, 90°, 180° and 270°. The concentric rings in the graph represent the brightness of the lights with steps of 25%, with the external ring 6 being 100%. As the rotation of the upper element occurs, a cardioid shape 7 appears by plotting the brightness as a function of the angle of rotation. According to the plot at 0° of rotation, brightness is 0%. Rotation up to 90° produces an increase in brightness to 50%. Maximum (100%) brightness is reached upon a 180° rotation. As rotation continues, the brightness decreases to 50% at 270° and back to 0% at 0°.

Figure 1C shows a graph depicting an alternative dimming curve to that mentioned in Figure 1B. Figure 1C shows a graph in polar coordinates, having as dimensions the angle of rotation and distance between permanent magnet and sensing device. Figure 1C represents rotation and brightness of the light as a function of the rotation angle of the light fixture. The external circle is marked with degrees that correspond to the angles of rotation, i.e. 0°, 90°, 180° and 270°. The concentric rings in the graph represent the brightness of the lights with steps of 25%, with the external ring 54 being 100%. As the rotation of the upper element occurs, a spiral shape 53 appears by plotting the brightness as a function of the angle of rotation.
According to the plot at 0° of rotation, brightness is 0%. Rotation up to 90° produces an increase in brightness to 25%. Rotation up to 180° produces an increase in brightness to 50%. Rotation up to 270° produces an increase in brightness to 75%. Maximum (100%) brightness is reached upon a 259° rotation. Upon returning to 0°, the brightness reduces immediately to 0°

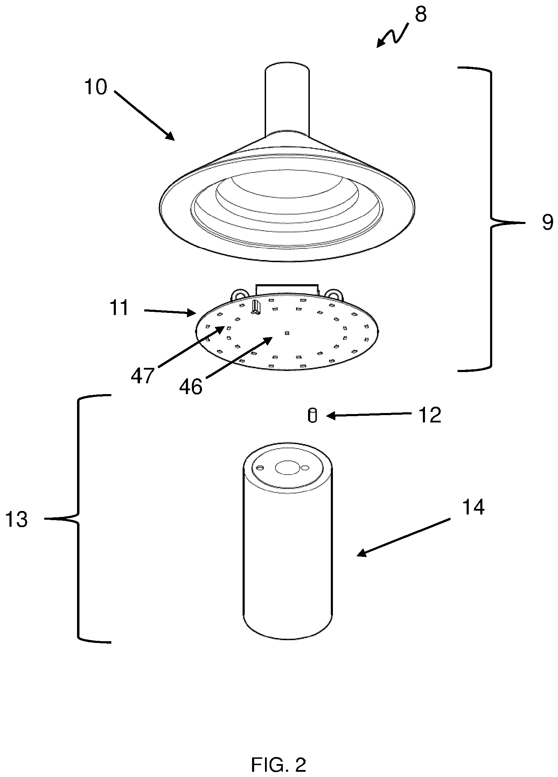

Figure 2 is an exploded view of the light fixture 8 in which the components of the upper element 9 and of the lower element 13 are shown.
The upper element 9 has a rotatable disc 11 comprising LEDs 47 and a chip 46, which is a magnetic sensor device being able to measure at least one magnetic field component and configured to determine an angular position of the permanent magnet 12 located at a certain distance from the device.
The lower element 13 is shown having a permanent magnet 12 located within its body 14.

The upper element 9 may also comprise a topping element 10 fastened to rotatable disc 11, protecting the rotatable disc 11 and allowing for easy handling of the light fixture.
The light fixture 8 can be handle by the user by either holding the body 14 or by holding the topping element 10.

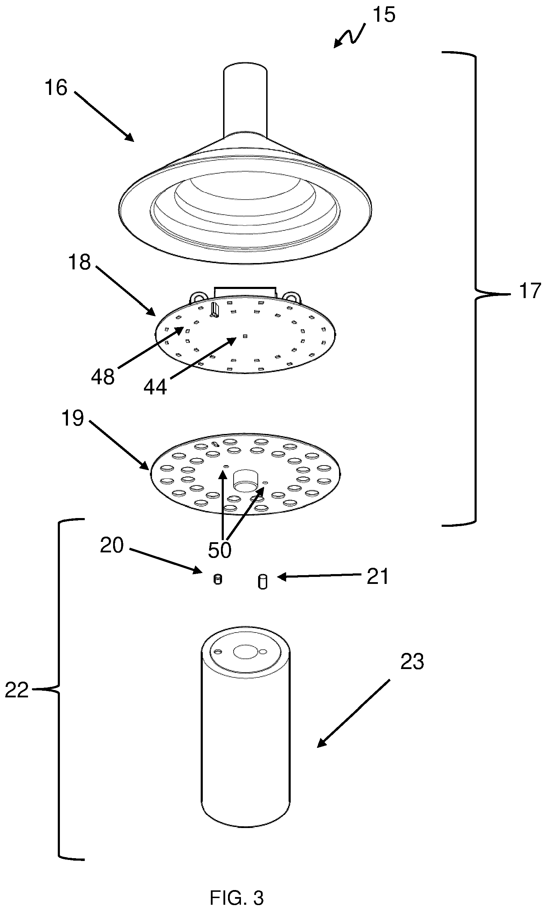

Figure 3 is an exploded view of the light fixture 15 in which the components of the upper element 17 and of the lower element 22 are shown.
The upper element 17 has a disc 18 comprising LEDs 48 and a chip 44, which is a magnetic sensor device being able to measure at least one magnetic field component and configured to determine an angular position of the permanent magnet 21 located at a certain distance from the device.
The disc 18 is placed onto a rotatable plate 19, having perforations allowing for transmittance of the light beam originated by the LEDs 48.
The rotatable plate 19 has also recesses 50 complementary to the ball plunger 20. The lower element 22 is shown having a permanent magnet 21 and a ball plunger 20 located within its body 23.

The upper element 17 may also comprise a topping element 16 fastened to rotatable plate 19 and protecting the disc 18 and allowing for easy handling of the light fixture.
Light fixture 15 may be handle by the user by either holding the body 23 or by holding the topping element 16.

When a user would like to adjust the light brightness may rotate the upper element 17 either in a clockwise or counter clockwise direction along the longitudinal axis of the light fixture.
At a determined degree of rotation, the ball plunger 20 will snap into one of the two recesses 50 providing a snap engagement producing a distinct audible sound and/or a tactile signal that will be felt by the user.

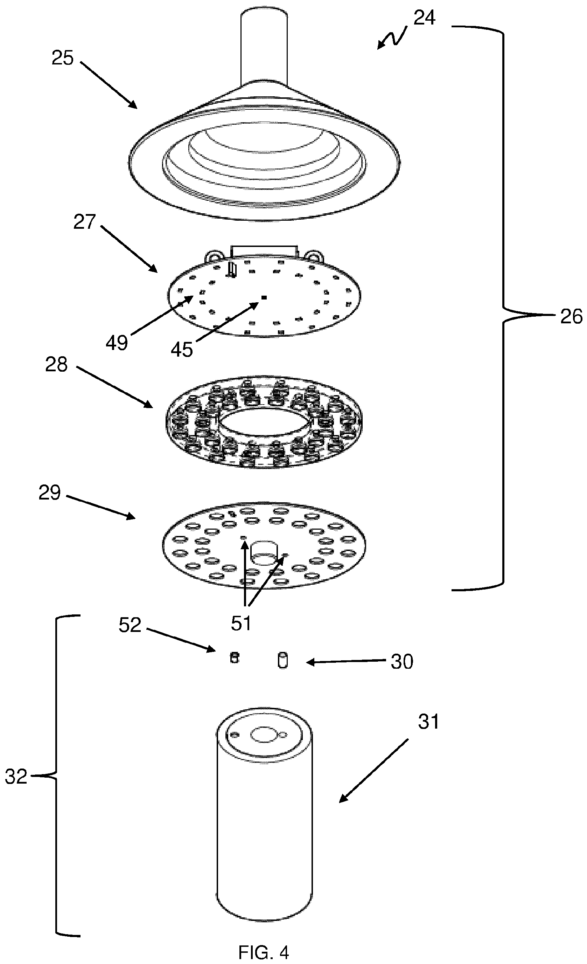

Figure 4 is an exploded view of the light fixture 24 comprising optical means 28 according to some further embodiments of the invention.

Figure 4 is an exploded view of the light fixture 24 in which the components of the upper element 26 and of the lower element 32 are shown.
The upper element 26 has a disc 27 comprising LEDs 49 and a chip 45, which is a magnetic sensor device being able to measure at least one magnetic field component and configured to determine an angular position of the permanent magnet 30 located at a certain distance from the device.
The disc 27 is placed onto a rotatable plate 29, having perforations allowing for transmittance of the light beam originated by the LEDs 49.
The rotatable plate 29 has also recesses 51 complementary to ball plunger 52.
The lower element 32 is shown having a permanent magnet 30 and a ball plunger 52 located within its body 31.

The upper element 26 may also comprise a topping element 25 fastened to rotatable plate 29 and protecting the disc 27 and allowing for easy handling of the light fixture.
Figure 4 shows the same light fixture of figure 3 in which a disc 28 comprising optical lenses is added between the disc 27 and the rotatable plate 29.
The presence of disc 29 enhances the light the emission of the LEDs 49.

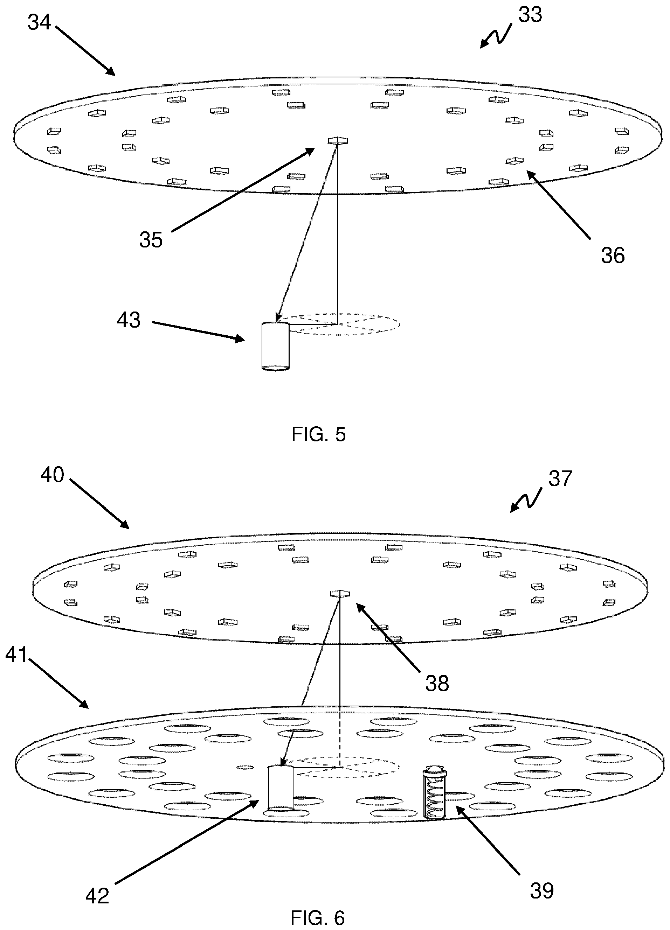

Figure 5 is a schematic illustration of the essential features of the magnetic rotary dimming system 33. The magnetic rotary dimming system 33 comprises a disc 34 comprising LEDs 36 and a chip 35. The chip 35 have a magnetic sensor being able to measure at least one magnetic field component of the permanent magnet 43 and is configured to determine an angular position of a permanent magnet 43.

Figure 6 is a schematic illustration of the magnetic rotary dimming system 37 in which the disc 40 having magnetic sensor chip 38 configured to determine an angular position of a permanent magnet 42 is located onto rotary plate 41. Rotary plate 41 is shown with recesses complementary to ball plunger 39.

Although the present invention has been described in connection with the specified embodiments, it should not be construed as being in any way limited to the presented examples. The scope of the present invention is set out by the accompanying claim set. In the context of the claims, the terms "comprising" or "comprises" do not exclude other possible elements or steps. In addition, the mentioning of references such as "a" or "an" etc. should not be construed as excluding a plurality. The use of reference signs in the claims with respect to elements indicated in the figures shall also not be construed as limiting the scope of the invention. Furthermore, individual features mentioned in different claims, may possibly be advantageously combined, and the mentioning of these features in different claims does not exclude that a combination of features is not possible and advantageous.

## Claims

1. A light fixture (1, 8, 15, 24) comprising:
- one or more sources of light (36, 47, 48, 49);
- a magnetic rotary dimming system comprising
- a movable plate (11, 19, 29, 34, 41) rotatable around an axis of said plate;
- a permanent magnet (12, 21, 30, 43, 42);
- a magnetic sensor device (35, 38, 44, 45, 46) located onto said movable plate mounted at a distance from said permanent magnet;
wherein said magnetic sensor device comprises at least one magnetic sensor for measuring at least one magnetic field component and said magnetic sensor is configured for determining an angular position of said permanent magnet;
- electronics connecting said one or more sources of light and said magnetic sensor device, said electronics configured to dim said one or more sources of light based on the detection of the angular position of said permanent magnet.

2. The light fixture according to claim 1 comprising:
- a light fixture body having an upper (2, 9, 17, 26) and a lower element (3, 13, 22, 32) configured to rotate in respect to each other around a central axis of said light fixture body.

3. The light fixture according to claim 2, wherein said lower element comprises said permanent magnet (12, 21, 30, 43, 42) and wherein said upper element comprises said movable plate (11, 19, 29, 34, 41).

4. The light fixture according to claim 2, wherein said lower element comprises said movable plate and wherein said upper element comprises said permanent magnet.

5. The light fixture according to any of the preceding claims, wherein said electronics are located onto or are within said movable plate (11, 19, 29, 34, 41).

6. The light fixture according to any of the preceding claims, wherein said one or more sources of light (36, 47, 48, 49) are located onto or are within said movable plate (11, 19, 29, 34, 41).

7. The light fixture according to any of the preceding claims, wherein said one or more sources of light (36, 47, 48, 49) encircle said electronics.

8. The light fixture according to any of the preceding claims, further comprising:
- optical means (28) for enhancing light emission from said one or more sources of light.

9. The light fixture according to claim 8, wherein said optical means are or comprise one or more lenses (28) located onto or are within said movable plate (11, 19, 29, 34, 41).

10. The light fixture according to any of the preceding claims, wherein said one or more sources of light (36, 47, 48, 49) are Light Emitting Diodes (LEDs).

11. The light fixture according to any of the preceding claims 2-10, wherein said lower element comprises at least one protrusion (20, 39, 52) complementary to at least two recesses (50, 51) on said movable plate, thereby providing a visual, audible or tactile signal at a determined angle of rotation.

12. The light fixture according to claim 11, wherein said at least one protrusion is or comprise a spring plunger, such as a ball plunger (20, 39, 52).

13. The light fixture according to any of the preceding claims, wherein said movable plate has a top and a bottom surface.

14. The light fixture according to claim 13, wherein said at least two recesses are holes on the bottom surface of said movable plate.

15. The light fixture according to any of the preceding claims 6-14, wherein said optical means are located on or are within said top surface of said movable plate.
